**Europäisches Patentamt**

**European Patent Office**

**Office européen des brevets**

(19)

(11) **EP 1 403 715 A2**

(12) **EUROPEAN PATENT APPLICATION**

(43) Date of publication:
**31.03.2004 Bulletin 2004/14**

(51) Int Cl.7: **G03F 7/20**

(21) Application number: **03256103.7**

(22) Date of filing: **29.09.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **30.09.2002 EP 02256792**

(71) Applicant: **ASML Netherlands B.V.**
**5503 LA Veldhoven (NL)**

(72) Inventors:
• **Kurt, Ralph**
  **5655 CG Eindhoven (NL)**
• **Kolesnychenko, Aleksey**
  **6525 JB Nijmegen (NL)**

(74) Representative: **Leeming, John Gerard**
**J.A. Kemp & Co.,**
**14 South Square,**
**Gray's Inn**
**London WC1R 5JJ (GB)**

(54) **Lithographic apparatus and device manufacturing method**

(57) A lithographic apparatus having means for supplying to a space in the apparatus at least one of one or more perhalogenated $C_1$-$C_6$ alkanes and one or more compounds consisting essentially of one or more nitrogen atoms and one or more atoms selected from hydrogen, oxygen and halogen. The activation of the alkane(s) and compound(s) by application of suitable activating means provides reactive species which are capable of highly selective etching of hydrocarbon species whilst minimising damage to sensitive optical surfaces.

**Fig. 1**

EP 1 403 715 A2

## Description

An embodiment of the present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion at one time; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from United States patent US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in United States patent US 5,969,441 and PCT patent application WO 98/40791, incorporated herein by reference.

An embodiment of the present invention is directed to low wavelength lithography systems such as those operating at 193nm and 157nm as well as extreme ultraviolet (EUV) lithography tools. Typically, EUV systems operate using a wavelength of below about 50nm, preferably below about 20nm and most preferably below about 15nm. An example of a wavelength in the EUV region which is gaining considerable interest in the lithography industry is 13.4nm, though there are also other promising wavelengths in this region, such as 11nm, for example.

In all of the above-mentioned systems, radiation-induced carbon contamination, causing the formation of films on optical elements, is a considerable problem. Even very thin carbon films can absorb a remarkable amount of the projection beam leading to a reduction in energy throughput in the optical train. Further, these carbon films may be non-homogeneous and as such can result in phase shifts and patterning errors. An effective strategy is therefore required to mitigate the effects of carbon contamination.

A standard approach used to date to address such problems involves the addition of $O_2$ and/or $H_2$ gas to the system in relatively high concentrations, followed by UV irradiation. However, this known technique has inherent disadvantages. In the case of optical lithography (e.g. 193nm and 157nm systems), it is thought that cleaning of the carbon contamination occurs through direct cracking of hydrocarbons in the gas phase by photons. Whilst this technique has been shown to reduce the rate of carbon growth in some situations, a temporarily higher hydrocarbon partial pressure is induced by the cracking process. This in turn subsequently induces the growth of a carbon film. Thus, the known technique is not effective in all situations.

More significant problems are experienced when the technique is applied to EUV systems. EUV tools typically employ multi-layer mirrors, which have highly sensitive surfaces. The standard $O_2$/UV cleaning method frequently not only etches away the carbon film on the surface of the mirror, but also damages the capping layer of the mirror. Such damage is typically irreversible and hence leads to a loss in reflectivity. An improved carbon cleaning method is therefore required, in particular in the field of EUV lithography.

It is an aim of an embodiment of the present invention to provide a lithographic projection apparatus comprising means for in-situ control of molecular contamination, which means can effectively be used in both DUV and EUV lithography.

This and other aims are addressed according to an embodiment of the invention in a lithographic apparatus as specified in the opening paragraph, having supply means for supplying to a space in said apparatus at least one of:

- one or more perhalogenated $C_1$-$C_6$ alkanes; and
- one or more compounds consisting essentially of one or more nitrogen atoms and one or more atoms selected from hydrogen, oxygen and halogen,

characterized in that the apparatus contains the said one or more alkanes and/or one or more compounds.

The lithographic apparatus of the invention provides a supply of one or more of the compounds set out above, typically together with nitrogen, hydrogen and/or one or more inert gases. The compound, or mixture of compounds, provided to the space is hereinafter referred to as the composition. The composition may consist of a single compound in pure form or may be a mixture of compounds.

The composition is supplied to a space in the apparatus, for example into the projection system. Activation of this composition either by applying the projection beam to the space containing the composition, or by use of an alternative activation source, leads to the excitation or dissociation of the compounds into various reactive species. These reactive species act as highly selective etching components, efficiently removing hydrocarbons without causing damage to the surface of any EUV mirrors present. In addition, the compositions used in the present invention typically provide a high etching rate of hydrocarbon species. Their light absorption is also generally low and the introduction of such materials into the optical train therefore has little or no adverse effect on transmissivity.

In a preferred embodiment of the invention, the composition comprises nitrogen dioxide. Nitrogen dioxide possesses various properties which make it more advantageous than oxygen as a cleaning agent. Firstly, it has a much lower dissociation energy than oxygen and can therefore easily be dissociated by photons and secondary electrons. Secondly, the activation of nitrogen dioxide leads to the formation of ozone, itself a highly effective etching agent. Thirdly, the sticking probability for nitrogen dioxide is significantly higher than that for oxygen, ensuring that a large amount of the cleaning agent is present on the surfaces to be cleaned.

As a result of these advantages, cleaning can be carried out using much lower pressures of cleaning agent than are required in a corresponding process where oxygen is used. Further, the more efficient nitrogen dioxide cleaning technique allows a reduced cleaning time to be employed, leading to a reduction in the downtime in the system.

According to a further aspect of the invention there is provided a device manufacturing method comprising:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,

characterized by:

- supplying to a space through which said projection beam passes at least one of:

- one or more perhalogenated $C_1$-$C_6$ alkanes; and
- one or more compounds consisting essentially of one or more nitrogen atoms and one or more atoms selected from hydrogen, oxygen and halogen; and

- causing excitation and/or dissociation of a plurality of the one or more alkanes and/or one or more compounds.

Although specific reference may be made in this text to the use of the apparatus according to an embodiment of the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:

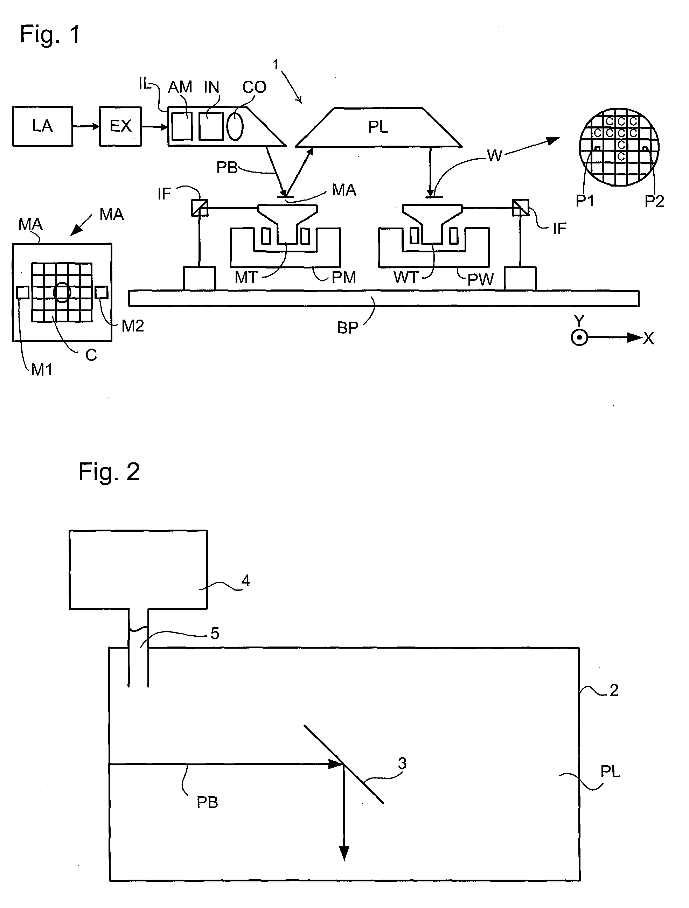

Figure 1 depicts a lithographic projection apparatus according to an embodiment of the invention; and Figure 2 depicts the radiation system of a lithographic apparatus according to an embodiment of the invention.

In the Figures, corresponding reference symbols indicate corresponding parts.

Embodiment 1

Figure 1 schematically depicts a lithographic projection apparatus according to a particular embodiment of the invention. The apparatus comprises:

a radiation system Ex, IL, for supplying a projection beam PB of radiation (e.g. UV/DUV/EUV radiation), which in this particular case also comprises a radiation source LA;

· a first object table (mask table) MT provided with a mask holder for holding a mask MA (e.

*g.* a reticle), and connected to first positioning means for accurately positioning the mask with respect to item PL;

· a second object table (substrate table) WT provided with a substrate holder for holding a substrate W (*e.g.* a resist-coated silicon wafer), and connected to second positioning means for accurately positioning the substrate with respect to item PL;

· a projection system ("lens") PL (*e.g.* a refractive/catadioptric lens system/mirror group) for imaging an irradiated portion of the mask MA onto a target portion C (*e.g.* comprising one or more dies) of the substrate W.

As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* an Hg lamp/an excimer laser/a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. An embodiment of the current invention encompasses at least these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected at one time (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", e.g. the y direction) with a speed *v*, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or 1/5). In this manner, a relatively large target portion C can be exposed, without having to compromise on resolution.

Figure 2 schematically depicts the projection system of a specific embodiment of the invention in more detail. In this case, the space to which the composition is supplied is the projection system. In alternative embodiments, the space is typically any area in the apparatus through which the projection beam passes. Preferred spaces are those containing at least a part of the radiation system and/or at least a part of the projection system. Preferably, the space contains at least one mirror.

As depicted in Figure 2, the projection system comprises a mirror 3 and optionally various other optical components as described above with reference to Figure 1. The projection system is contained within chamber 2. The chamber is supplied with the composition disclosed herein from supply means 4, which may be a pressurized container containing a liquid or gaseous form of the composition. The composition is supplied to the chamber by means of inlet 5, which comprises a valve. The composition is typically supplied to the chamber in gaseous form or as a beam of molecules. However, it may alternatively be supplied in the form of a liquid or solid. The said liquid is then evaporated or the said solid is sublimed, providing the composition in the space in gaseous form. A further means for supplying the composition is to provide the composition encapsulated in microporous media. For example, a zeolite having molecules of the composition in the cavities in its structure may be provided. Once introduced into the space, the zeolite is, for example, heated in order to liberate the composition.

Where the composition contains more than one compound, two or more supply means may be present, each supply means, for example, supplying one compound to the space. Alternatively, each compound may be supplied via the same supply means either together or at different times. Any reference above to the supply of the composition therefore also includes reference to the supply of one of the compounds of the composition.

The lithographic apparatus contains the composition. For example the composition may be present in supply means 4 and/or in chamber 2 (typically the projection system).

After its introduction into the space in the apparatus, the composition is activated. Typically, activation is carried out at a separate time from, for example prior to, the step of exposing the substrate. The space is then optionally purged or evacuated to remove the composition prior to said exposure. Activation can be achieved, for example, by irradiating the space containing the composition with the projection beam. However, alternative means of activation may be used, provided the means is one capable of dissociating or exciting at least some (and preferably the majority) of the molecules in the composition. Examples of alternative activation means are additional UV sources, for example a DUV or EUV source, plasma sources, an electrical or magnetic field or electron irradiation. It is preferred that the activation means is the projection beam itself, in particular when using an EUV projection beam, since this leads to a high degree of dissociation of the compounds in the composition and thus enhanced cleaning efficiency.

Activation occurs principally by two means. Firstly, dissociation or excitation may occur directly by photons when a UV source is used as the activation means. Secondly, activation may occur due to secondary electrons produced, for example at an irradiated surface or by an electron source. Activation leads to the production of reactive species, in particular molecules which have been excited to a higher energy level and fragments of dissociated molecules.

The reactive species produced provide highly selective etching of carbon films. This is demonstrated by tests carried out on the compositions described herein showing that $sp^2$ carbon, i.e. aliphatic hydrocarbon, amorphous and graphitic carbon, is selectively etched in favor of $sp^3$ carbon. Whilst dissociation of hydrocarbons by UV leads to both $sp^2$ and $sp^3$ carbon, carbon-contamination layers in lithographic apparatus have been shown to be formed largely of nano-structured graphitic-like films formed from $sp^2$ carbon. Thus, the compositions disclosed herein are highly selective for the particular type of contamination which is problematic in lithography apparatus.

The compositions disclosed herein are preferably easily dissociated into reactive species on application of radiation or other activating means. A high sticking coefficient is also advantageous since this enhances the possibility of dissociation and the likelihood of reaction with $sp^2$ carbon.

Typically, the composition comprises or consists essentially of one or more compounds selected from perhalogenated $C_1$-$C_6$ alkanes, nitrogen dioxide, nitrogen oxoacids, nitrogen hydrides and salts of nitrogen hydrides, said salts consisting of nitrogen, hydrogen, oxygen and halogen atoms. For example, the composition may comprise or consist essentially of one or more compounds selected from perhalogenated $C_1$-$C_6$ alkanes, nitrogen oxoacids, nitrogen hydrides and salts of nitrogen hydrides, said salts consisting of nitrogen, hydrogen, oxygen and halogen atoms. In these salts, the halogen is typically fluorine, chlorine or bromine, preferably fluorine. Typically, the perhalogenated $C_1$-$C_6$ alkanes are perfluorinated $C_1$-$C_6$ alkanes. Preferred $C_1$-$C_6$ alkanes are $C_1$-$C_4$ alkanes, in particular methane and ethane. Thus, preferred perhalogenated $C_1$-$C_6$ alkanes are perfluorinated $C_1$-$C_4$ alkanes, in particular perfluoromethane and perfluoroethane. Typically the nitrogen oxoacid is nitric acid ($HNO_3$). The nitrogen hydrides are compounds consisting only of nitrogen and hydrogen atoms. Examples of nitrogen hydrides include ammonia ($NH_3$), hydrazine ($N_2H_4$), hydrogen azide ($HN_3$), ammonium azide ($NH_4N_3$), hydrazinium azide ($N_2H_5N_3$), diazene ($N_2H_2$) and tetrazene ($H_2N$-$N$=$N$-$NH_2$). Preferred nitrogen hydrides are ammonia, diazene and hydrazine, in particular ammonia. Typically the salts of nitrogen hydrides are ammonium salts. Examples of ammonium salts include ammonium hydroxide and ammonium halides such as ammonium fluoride, ammonium chloride and ammonium bromide.

Thus, preferred compositions comprise or consist essentially of one or more compounds selected from perfluorinated $C_1$-$C_4$ alkanes, nitrogen dioxide, nitric acid, nitrogen hydrides and ammonium salts. Examples of preferred compositions comprise or consist essentially of one or more compounds selected from perfluorinated $C_1$-$C_4$ alkanes, nitric acid, nitrogen hydrides and ammonium salts. More preferred compositions comprise or consist essentially of one or more compounds selected from tetrafluoromethane, nitrogen dioxide, nitric acid, ammonium fluoride, ammonium hydroxide, ammonia, diazene and hydrazine, for example tetrafluoromethane, nitric acid, ammonium fluoride, ammonium hydroxide, ammonia, diazene and hydrazine.

Compositions that consist essentially only of nitrogen and/or hydrogen containing species, optionally together with $N_2$, $H_2$ and/or one or more inert gases, are particularly advantageous when ruthenium mirrors are employed. These compounds act as highly selective etching agents, removing substantially all hydrocarbons present in the system while causing little, if any, damage to ruthenium mirrors. Thus, in systems employing ruthenium mirrors, preferred compositions comprise or consist essentially of nitrogen hydrides optionally together with $N_2$, $H_2$ and/or one or more inert gases. More preferred compositions comprise or consist essentially of one or more compounds selected from ammonia, diazene and hydrazine. Most preferred compositions comprise or consist essentially of ammonia. Typically, each of the above compositions comprises or consists essentially of the above specified nitrogen hydrides together with $N_2$, $H_2$ and/or one or more inert gases.

Whilst the nitrogen hydrides provide highly selective etching, other compositions, such as those containing halogen or hydroxide groups, typically provide a faster etching rate. Where a fast etching rate is required, a suitable composition would therefore comprise or consist essentially of one or more compounds selected from perhalogenated $C_1$-$C_6$ alkanes, nitrogen oxoacids and ammonium salts, said salts consisting essentially of nitrogen, hydrogen, oxygen and halogen atoms. Preferably such a composition contains or consists essentially of one or more compounds selected from perfluorinated $C_1$-$C_4$ alkanes, nitric acid and ammonium salts. More preferably a composition for fast etching contains or consists essentially of one or more compounds selected from perfluoromethane, perfluoroethane, nitric acid, ammonium fluoride and ammonium hydroxide. These compositions for fast etching are, for example, used when rapid etching of a thick layer of hydrocarbons is required. Nitrogen hydride based compositions are typically employed for general use, due to their improved selectivity. Typically, each of the above compositions comprises or consists essentially of the above specified compounds together with $N_2$, $H_2$ and/or one or more inert gases.

In an alternative embodiment of the invention, the composition comprises or consists essentially of nitrogen dioxide, which has been found to be a particularly advantageous cleaning substance due to its low dissociation energy and high sticking coefficient. Nitrogen dioxide can be easily dissociated into reactive species such as atomic oxygen and reactive nitrogen oxides, for example:

$$NO_2 + h\nu \rightarrow NO + O$$

The dissociation energy for a nitrogen dioxide molecule is much lower than that for an oxygen molecule. As a result, the nitrogen dioxide molecule can be dissociated directly by a photon with a wavelength of only 397 nm. This is in contrast to an oxygen molecule, which requires 242 nm for dissociation to occur. Dissociation of nitrogen dioxide via secondary electrons also occurs more easily. Furthermore, recombination of the reactive species to re-form a nitrogen dioxide molecule is not favored. Thus, a high proportion of reactive species can be made available in the optical train through a relatively low energy input.

A further advantage of the use of nitrogen dioxide relates to its high sticking coefficient. The physisorption of nitrogen dioxide molecules onto carbon-like surfaces is relatively strong, in particular when compared with the strength of comparable bonds formed by molecular oxygen to carbon-like surfaces. The sticking probability of nitrogen dioxide on silicon, ruthenium and even carbon surfaces is therefore close to one. Given this strength of bonding, a large number of nitrogen dioxide molecules will be bound to the surfaces of the optical elements at any one time. This provides localization of the cleaning agent in the precise position where cleaning is required and thus increases the efficiency of the process.

Nitrogen dioxide can be delivered to the system either alone, mixed with inert gases, or mixed with oxygen, hydrogen and/or water. It has been found that a composition comprising nitrogen dioxide in combination with existing cleaning agents, in particular oxygen, hydrogen and/or water provides a highly effective cleaning process. In particular, the use of nitrogen dioxide in the presence of oxygen leads to the production of ozone, known to be a particularly effective cleaning agent. For example, ozone can be produced as follows:

$$NO_2 + h\nu \rightarrow NO + O$$

$$O + O_2 \rightarrow O_3 \text{ (ozone)}$$

or

$$VOCs + NOx + h\nu \rightarrow O_3 + \text{other pollutants}$$

where VOCs represent volatile organic compounds.

Typically, the gaseous composition is provided to the space at a partial pressure which is at least 5, preferably at least 10 times the partial pressure of hydrocarbon gases in the space. In an EUV system, the gaseous composition is supplied preferably in a ratio of $NO_2$: CxHy of $10^2$-$10^4$, typically as a continuous or quasi-continuous operation. The actual partial pressure of gaseous composition introduced is typically in the order of $10^{-4}$ to $10^{-5}$ mbar. Where the gaseous composition comprises an active cleaning agent as well as inert species, the partial pressures mentioned above typically refer to the pressure of the cleaning agent. In general, the skilled person will be able to select suitable partial pressures for use based on the techniques known in the art. However, the lower absorption rate of the gaseous compositions disclosed herein means that higher partial pressures can be tolerated than may have been used with the standard $O_2$/UV technique.

Whilst specific embodiments of the invention have been described above, it will be appreciated that the invention may be practiced otherwise than as described. The description is not intended to limit the invention.

**Claims**

1. A lithographic projection apparatus comprising:

   - a radiation system for providing a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate,
   - supply means for supplying to a space in said apparatus at least one of:

     - one or more perhalogenated $C_1$-$C_6$ alkanes; and
     - one or more compounds consisting essentially of one or more nitrogen atoms and one or more atoms selected from hydrogen, oxygen and halogen,

   **characterized in that** the apparatus contains the said one or more alkanes and/or one or more compounds.

2. An apparatus according to claim 1 **characterized by** supply means for supplying to a space in said apparatus a composition consisting essentially of at least one of:

   - one or more perhalogenated $C_1$-$C_6$ alkanes; and
   - one or more compounds consisting essentially of one or more nitrogen atoms and one or more atoms selected from hydrogen, oxygen and halogen;

   optionally together with $N_2$ and/or $H_2$ and/or one or more inert gases.

3. An apparatus according to claim 1 or 2, wherein the one or more alkanes includes tetrafluoromethane.

4. An apparatus according to any one of the preceding claims, wherein the one or more compounds includes one or more nitrogen hydrides.

5. An apparatus according to any one of the preceding claims, wherein the one or more compounds includes at least one of ammonia, diazene, hydrazine and salts thereof.

6. An apparatus according to any of the preceding claims, wherein the one or more compounds includes nitric acid.

7. An apparatus according to any one of the preceding claims, wherein said supply means further supplies at least one of $N_2$ and $H_2$.

8. An apparatus according to any one of the preceding claims, wherein the one or more compounds includes nitrogen dioxide.

9. An apparatus according to claim 8, wherein said supply means further supplies one or more of oxygen, hydrogen and water.

10. An apparatus according to any one of the preceding claims, wherein the projection beam passes through the space.

11. An apparatus according to any one of the preceding claims, wherein the space comprises at least a part of the radiation system and/or at least a part of the projection system.

12. An apparatus according to any one of the preceding claims, further comprising means for exciting and/or dissociating a plurality of molecules of the one or more alkanes and/or one or more compounds.

13. A device manufacturing method comprising:

    - providing a substrate that is at least partially covered by a layer of radiation-sensitive material;
    - providing a projection beam of radiation using a radiation system;
    - using patterning means to endow the projection beam with a pattern in its cross-section;
    - projecting the patterned beam of radiation onto a target portion of the layer of radiation-sensitive material,

    **characterized by**:

    - supplying to a space through which said projection beam passes at least one of:

      - one or more perhalogenated $C_1$-$C_6$ alkanes; and
      - one or more compounds consisting essentially of one or more nitrogen atoms and one or more atoms selected from hydrogen, oxygen and halogen; and
      - causing excitation and/or dissociation of a plurality of the one or more alkanes and/or the one or more compounds.

**Fig. 1**

**Fig. 2**